# EUROPEAN PATENT SPECIFICATION

(11) **EP 0 394 053 B1**
(45) Date of publication and mention of the grant of the patent: **06.10.1993**
(21) Application number: 90304235.6
(22) Date of filing: 20.04.1990
(51) Int. Cl.: H05K 9/00

(54) **Miniature mobile radio communication equipment having a shield structure**
Mobiles Miniatur-Funkgerät mit Abschirmungsanordnung
Equipment miniature de radiocommunication mobile ayant dispositif de blindage

(30) Priority: 20.04.1989 JP 100612/89; 05.12.1989 JP 316669/89
(43) Date of publication of application: 24.10.1990
(73) Proprietor: NEC CORPORATION, Tokyo (JP)
(72) Inventor: Tamura, Yoshiharu, c/o NEC Corporation, Tokyo (JP); Hashimoto, Kazuya, c/o NEC Corporation, Tokyo (JP)
(74) Representative: Abnett, Richard Charles

(56) References cited:
- EP-A- 0 169 329
- DE-A- 3 604 730
- DE-U- 1 980 769

## Description

### BACKGROUND OF THE INVENTION

The present invention relates to miniature mobile radio communication equipment having a simultaneous transmitting and receiving capability and which may be carried by a user or mounted on a vehicle as needed. More specifically, the present invention is concerned with miniature mobile radio communication equipment having a shield structure which electromagnetically isolates a transmitting, a receiving and a control section of the equipment from one another to eliminate mutual interference (see for example EP-A-0169329).

A prerequisite with miniature mobile radio communication equipment is that its transmitting section, receiving section and control section be electromagnetically isolated from one another to eliminate mutual interference such as frequency coupling. In conventional equipment of this kind, the transmitting and receiving sections both are integrally mounted on a single printed circuit board and, therefore, apt to interfere with each other due to a common current which flows to ground. Usually, the arrangement of various parts and elements constituting the transmitting and receiving sections on the printed circuit board is elaborated to minimize the mutual interference. This, however, limits the positions and arrangement of the individual parts and elements on the printed circuit board and thereby the design freedom, obstructing the miniaturization of the equipment. With prior art vehicle-mounted radio communication equipment, it is a common practice to partition the interior of a casing into a plurality of compartments by walls and disposing each of transmitting, receiving and control sections in respective one of the compartments, thereby inhibiting such sections from interfering with each other. Although the compartment scheme is successful in enhancing the shield, it cannot be implemented without increasing the weight and volume of the equipment and is, therefore, not feasible for portable radio communication equipment.

### SUMMARY OF THE INVENTION

It is therefore an object of the present invention to provide miniature mobile radio communication equipment having a shield structure for eliminating mutual interference of a transmitting, a receiving and a control section of the equipment.

It is another object of the present invention to provide miniature mobile radio communication equipment having a shield structure which promotes the design freedom concerning the arrangement of a transmitting, a receiving and a control section on individual printed circuit boards.

It is another object of the present invention to provide generally improved miniature mobile radio communication equipment having a shield structure.

Miniature mobile radio communication equipment having a shield structure for electromagnetically shielding at least a transmitting and a receiving section from each other of the present invention as defined in claim 1 comprises a first printed circuit board loaded with various parts constituting the transmitting section on one surface thereof and having terminals of the parts connected on the one surface, a second printed circuit board loaded with various parts constituting the receiving section on one surface and having terminals of the parts connected on the one surface, the first and second printed circuit boards being located such that the other surfaces face each other, and a shielding device for electromagnetically shielding the transmitting and receiving sections from each other.

The invention further provides a method a defined in claim 12.

The above and other objects, features and advantages of the present invention will become more apparent from the following detailed description taken with the accompanying drawings in which:
Figs. 1 and 2 are respectively a plan view and a side elevation showing a mounting structure of prior art miniature mobile radio communication equipment;
Fig. 3 is a sectional side elevation of a specific shield structure of prior art vehicle-mounted radio communication equipment;
Fig. 4 is a view similar to Fig. 3, showing another specific shield structure of prior art vehicle-mounted radio communication equipment;
Fig. 5 is a sectional side elevation showing miniature mobile radio communication equipment embodying the present invention, particularly a shield structure thereof;
Fig. 6 is a view similar to Fig. 5, showing an alternative embodiment of the present invention;
Fig. 7 is a view also similar to Fig. 5, showing another alternative embodiment of the present invention; and
Fig. 8 is a sectional side elevation showing a modification of any of the illustrative embodiments and how the shield structure is fixed in place within a casing.

### DESCRIPTION OF THE PREFERRED EMBODIMENTS

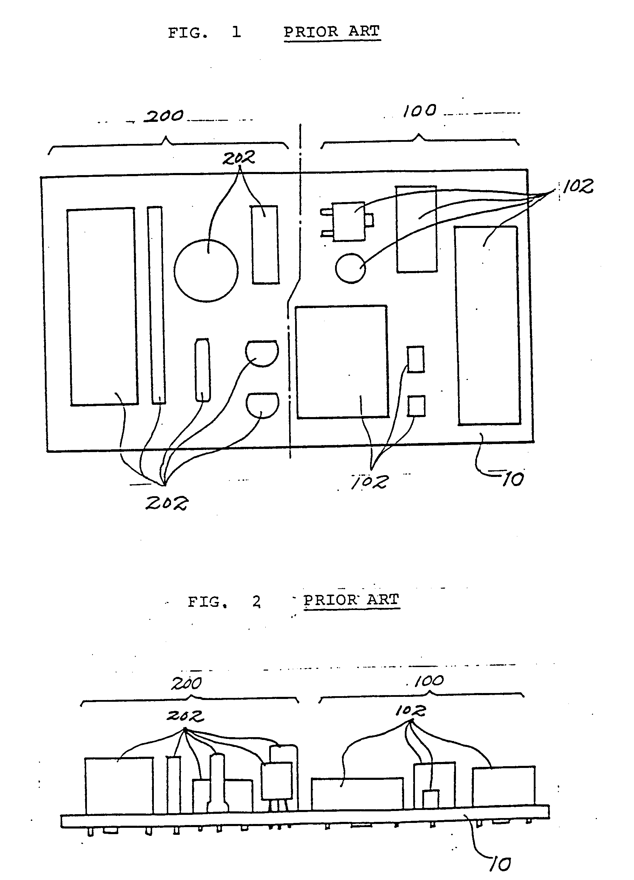

To better understand the present invention, a brief reference will be made to prior art radio communication equipment to which the present invention pertains, shown in Figs. 1 and 2. As shown, the prior art equipment has a single printed circuit board 10 which carries in a certain area of its one surface a number of parts 102 constituting a transmitting section 100. Loaded on another area of the same surface of the printed circuit board 10 as the transmitting section 100 are various parts 202 which constitute a receiving section 200. The transmitting section 100 and receiving section 200 are received in a casing, not shown, together with the printed circuit board 10. The terminals of the parts 102 and 202 protrude from the other surface of the printed circuit board 10 and are soldered or otherwise connected in an adequate manner. A problem with such a construction is that the transmitting section 100 and receiving section 200 sharing the same surface of the printed circuit board 10 are apt to interfere with each other due to a common current flowing to ground. It has been customary, therefore, to minimize the mutual interference of the two sections 100 and 200 by elaborating the arrangement of the parts 102 and 202 or by using a shield structure which electromagnetically isolates the sections 100 and 200 at a position indicated by a dash-and-dot line in Fig. 1. This kind of shield structure, however, imposes positional limitations on the various parts and thereby critically limits the design freedom, as discussed earlier. Moreover, such a configuration is contradictory to the increasing demand for miniature radio communication equipment.

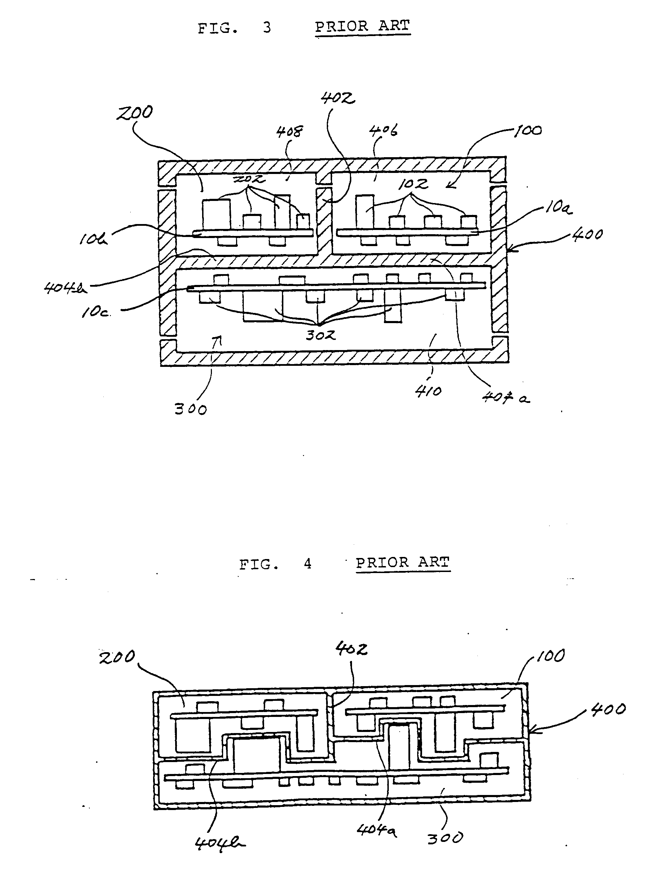

Fig. 3 indicates a shield structure available with prior art vehicle-mounted radio communication equipment. In the figure, similar components are designated by like reference numerals, and redundant description will be avoided for simplicity. As shown, the parts 102 and 202 constituting the transmitting section 100 and receiving section 200, respectively, are each mounted on respective one of independent printed circuit board 10a and 10b. Various parts constituting a control section 300 are loaded on another printed circuit board 10c. A casing 400 is implemented as a die casing of aluminum and has thereinside three compartments 406, 408 and 410 which are defined by relatively thick walls 402, 404a and 404b. The transmitting section 100, receiving section 200 and control section 300 are respectively received in the compartments 406, 408 and 410 and thereby electromagnetically isolated from one another. While such a shield structure may guarantee desirable electromagnetic isolation, it increases the overall weight and volume of the equipment and is, therefore, not feasible for portable radio communication equipment. The walls 402, 404a and 404b of the casing 400 may be thinned to reduce the overall weight, while the positions of the transmitting section 100, receiving section 200 and control section 300 in the casing 400 may be elaborated to reduce the overall volume, as shown in Fig. 4. However, a drawback with the structure of Fig. 4 is that not only the design freedom is limited due to the limitations as to the positions of the parts, but also the structure is complicated.

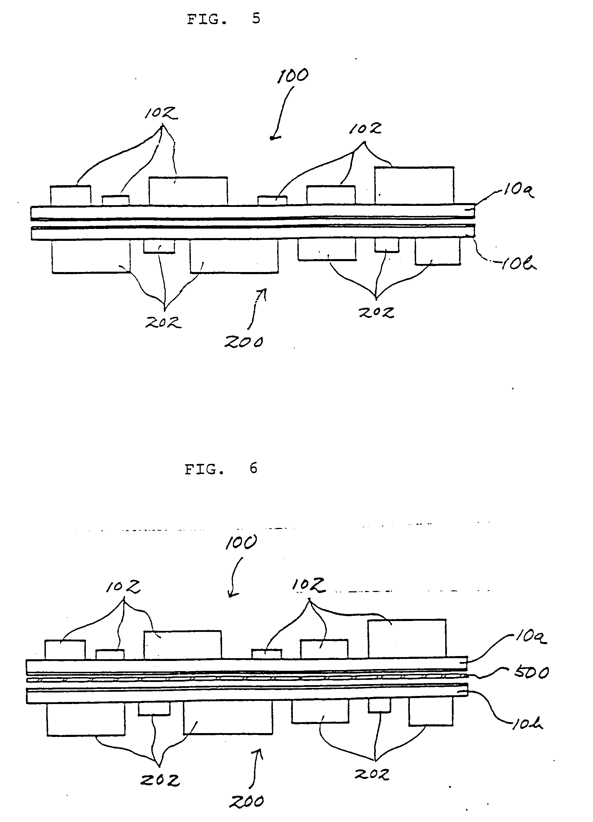

Preferred embodiments of the miniature mobile radio communication equipment in accordance with the present invention will be described with reference to Figs. 5 to 8. In the figures, parts and elements similar to those of the prior art described above are designated by like reference numerals.

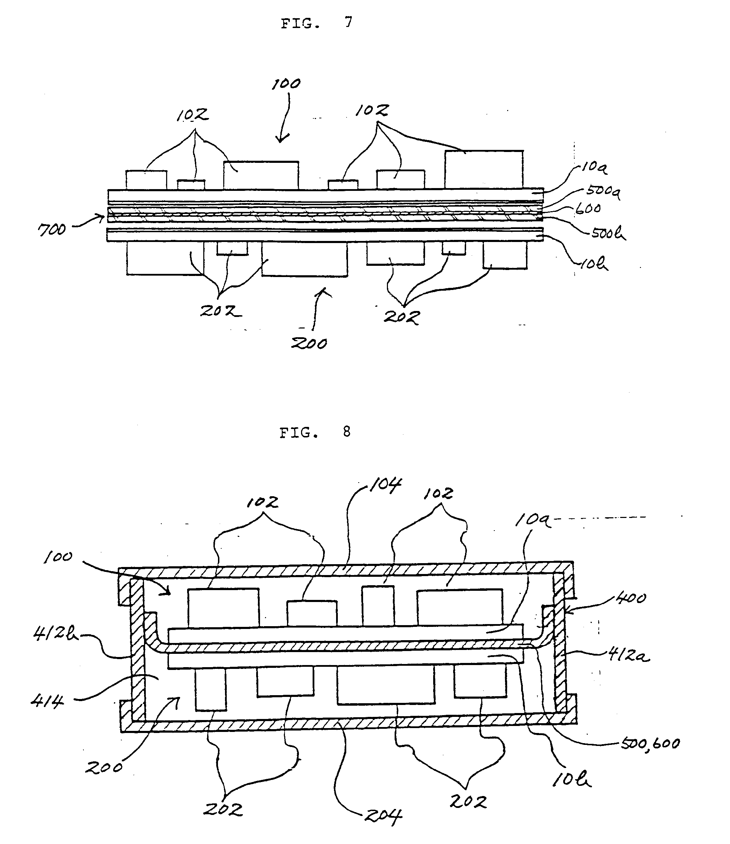

Fig. 5 shows a shield structure representative of an embodiment of the present invention. As shown, a printed circuit board 10a is loaded with various parts 102 constituting a transmitting section 100 on one surface thereof. The terminals of the parts 102 are connected on the same surface of the printed circuit board 10a by solder, for example. Another printed circuit board 10b is loaded with various parts 202 constituting a receiving section 200 on one surface thereof. The terminals of the parts 202 are connected on the same surface of the printed circuit board 10b by solder, for example. A ground pattern is provided on each major part of the other surfaces of the printed circuit boards 10a and 10b. Accommodated in a casing as shown in Fig. 8, the printed circuit boards 10a and 10b adjoin each other at a predetermined distance or contact each other, such that their surfaces where the terminals are soldered are located face-to-face. The printed circuit boards 10a and 10b are electrically interconnected as needed. In this configuration, the transmitting section 100 and receiving section 200 are electromagnetically shielded from each other. Specifically, the ground patterns provided on opposite surfaces of the printed circuit boards 10a an 10b play the role of shielding means for electromagnetically isolating the two sections 100 and 200 from each other and thereby inhibiting them from interfering with each other. Moreover, this shield structure does not need any shield plate or similar extra shield member between the transmitting section 100 and the receiving section 200, promoting the miniaturization of communication equipment. In addition, the freedom concerning the positions of the individual parts 102 and 202 on the printed circuit boards 10a and 10b, respectively, is enhanced.

Referring to Fig. 6, an alternative embodiment of the present invention is shown which includes an insulating sheet 500 intervening between the printed circuit boards 10a and 10b. The insulating sheet 500 serves to eliminate unexpected electric contact, e. g. , short circuit which might occur on the surfaces of the printed circuit boards 10a and 10b which face each other. When there is no fear of such short circuit or similar undesirable electric contact, the insulating sheet 500 may be replaced with a sheet of metal for the purpose of further enhancing the electromagnetic shield of the transmitting section 100 and receiving section 200.

Fig. 7 shows another alternative embodiment of the present invention which has shielding means in the form of a laminate sheet 700. Specifically, the laminate sheet 700 has a single sheet of metal 600 and two insulating sheets 500a and 500b provided on opposite sides of the sheet 600. The laminate sheet 700 is interposed between the printed circuit boards 10a and 10b. With this structure, the equipment is free from short circuit on the soldered surfaces of the printed circuit boards 10a and 10b and allows the sheet 700 to inhibit the transmitting section 100 and receiving section from interfering with each other.

In the embodiments shown and described, all the parts 102 and 202 loaded on the printed circuit boards 10a and 10b, respectively, are comprised of relatively short parts and thereby located at substantially the same level.

As shown in Fig. 8, the transmitting section 100 and receiving section 200 of any of the illustrative embodiments are accommodated in a casing 400. The casing 400 has thereinside a bore 414 which is defined by frame members 412a and 412b, a transmission cover 104, and a reception cover 204. The transmitting section 100 and receiving section 200 are fixed in place within the bore 414 by suitable fixing means. Specifically, when the printed circuit boards 10a and 10b and the shielding means in the form of the sheet 500 or 600 are connected integrally with each other as illustrated, opposite ends of the sheet 500 or 600 may be fixed to the frames 412a and 412b by screws or similar fastening means. In such a case, the sheet 500 or 600 will be maintained at the same potential as the frames 412a and 412b, while the transmission cover 104, reception cover 204 and frames 412a and 412b will be made of metal without exception.

While the illustrative embodiments have concentrated on the electromagnetic shield of the transmitting section 100 and receiving section 200, a similar shield structure is of course applicable to the control section for freeing the latter from interference.

In summary, in accordance with the present invention, a transmitting, a receiving and a control section are effectively electromagnetically shielded from each other by a simple structure. Especially, since the transmitting and receiving sections are constructed into a unit together with the shielding means, they can be tested easily and reliably to see their interactions.

## Claims

1. Miniature mobile radio communication equipment having a shield structure for electromagnetically shielding at least a transmitting and a receiving section from each other, comprising:
a first printed circuit board (10a) loaded with various parts (102) constituting the transmitting section (100) on one surface thereof and having terminals of said parts connected on the one surface;
a second printed circuit board loaded (106) with further various parts (202) constituting the receiving section (200) on one surface and having terminals of said parts connected on the one surface, said first and second printed circuit boards being located such that the other surfaces face each other; and
shielding means (500,600,700) for electromagnetically shielding the transmitting and receiving sections from each other.

2. Equipment as claimed in claim 1, wherein said first and second printed circuit boards are spaced apart from each other with said other surfaces adjoining each other.

3. Equipment as claimed in claim 1, wherein said first and second printed circuit boards are located with said other surfaces contacting each other.

4. Equipment as claimed in claim 1, wherein said shielding means comprises ground patterns respectively provided on opposite surfaces of said first and second printed circuit boards.

5. Equipment as claimed in claim 1, wherein said shielding means comprises an insulating sheet (500) interposed between said other surfaces of said first and second printed circuit boards.

6. Equipment as claimed in claim 1, wherein said shielding means comprises a sheet of metal (600) interposed between said other surfaces of said first and second printed circuit boards.

7. Equipment as claimed in claim 1, wherein said shielding means comprises a sheet of metal (600) interposed between said other surfaces of said first and second printed circuit boards, and two insulating sheets (500a,500b) respectively provided on opposite surfaces of said sheet of metal.

8. Equipment as claimed in claim 1, further comprising a casing (400) for receiving said first and second printed circuit boards and said shielding means.

9. Equipment as claimed in claim 8, wherein said casing comprises a transmission cover (104), a reception cover (204), and opposite frame members (412a,412b).

10. Equipment as claimed in claim 9, wherein said transmission cover, said reception cover and said frames are made of metal.

11. Equipment as claimed in claim 9, further comprising means for fixing said first and second printed circuit boards and said shielding means in said casing.

12. A method of mounting first and second radio sections of an equipment as claimed in claim 1, comprising the following steps of:
mounting said first radio section (100) on one surface of a first printed circuit board (10a) having a first ground pattern on the other surface thereof;
mounting said second radio section (200) on one surface of a second printed circuit board (10b) having a second ground pattern on the other surface thereof; and
placing the other surfaces of said first and second printed circuit boards to face each other.

## Patentansprüche

1. Mobiles Miniatur-Funkgerät mit einer Abschirmungsanordnung zum elektromagnetischen Voneinanderabschirmen mindestens eines Sende- und eines Empfangsabschnitts, mit:
einer ersten gedruckten Schaltung (10a), die mit verschiedenen, den Sendeabschnitt (100) bildenden Teilen (102) auf einer ihrer Seiten bestückt ist und bei der Anschlüsse der Teile auf dieser Seite miteinander verbunden sind,
einer zweiten gedruckten Schaltung (10b), die mit weiteren verschiedenen, den Empfangsabschnitt (200) bildenden Teilen (202) auf einer Seite bestückt ist und bei der Anschlüsse der Teile auf dieser Seite miteinander verbunden sind, wobei die erste und die zweite gedruckte Schaltung so angeordnet sind, daß die anderen Seiten einander gegenüberliegen, und
Abschirmeinrichtungen (500, 600, 700) zum elektromagnetischen Voneinanderabschirmen des Sende- und Empfangsabschnitt.

2. Gerät nach Anspruch 1, wobei die erste und zweite gedruckte Schaltung voneinander beabstandet sind, wobei die anderen Seiten aneinandergrenzen.

3. Gerät nach Anspruch 1, wobei die erste und zweite gedruckte Schaltung so angeordnet sind, daß die anderen Seiten einander berühren.

4. Gerät nach Anspruch 1, wobei die Abschirmeinrichtung jeweils auf gegenüberliegenden Seiten der ersten und zweiten gedruckten Schaltung vorgesehene Massemuster aufweist.

5. Gerät nach Anspruch 1, wobei die Abschirmeinrichtung eine zwischen den anderen Seiten der ersten und zweiten gedruckten Schaltung angeordnete Isolierschicht (500) aufweist.

6. Gerät nach Anspruch 1, wobei die Abschirmeinrichtung eine zwischen den anderen Seiten der ersten und zweiten gedruckten Schaltung angeordnete Metallschicht (600) aufweist.

7. Gerät nach Anspruch 1, wobei die Abschirmeinrichtung eine zwischen den anderen Seiten der ersten und zweiten gedruckten Schaltung angeordnete Metallschicht (600) und zwei jeweils an gegenüberliegenden Seiten der Metallschicht vorgesehene Isolierschichten (500a, 500b) aufweist.

8. Gerät nach Anspruch 1, ferner mit einem Gehäuse (400) zur Aufnahme der ersten und zweiten gedruckten Schaltung und der Abschirmeinrichtung.

9. Gerät nach Anspruch 8, wobei das Gehäuse eine Sendeabdeckung (104), eine Empfangsabdeckung (204) und gegenüberliegende Rahmenelemente (412a, 412b) aufweist.

10. Gerät nach Anspruch 9, wobei die Sendeabdeckung, die Empfangsabdeckung und die Rahmen aus Metall sind.

11. Gerät nach Anspruch 9, ferner mit einer Einrichtung zum Befestigen der ersten und zweiten gedruckten Schaltung und der Abschirmeinrichtung in dem Gehäuse.

12. Verfahren zum Montieren einer ersten und zweiten Funkan-Ordnung eines Geräts nach Anspruch 1, mit den folgenden Schritten:
Montieren des ersten Funkabschnitts (100) auf einer Seite einer ersten gedruckten Schaltung (10a) mit einem ersten Massemuster auf dessen anderer Seite,
Montieren des zweiten Funkabschnitts (200) auf einer Seite einer zweiten gedruckten Schaltung (10b) mit einem zweiten Massemuster auf dessen anderer Seite, und
Anordnen der anderen Seiten der ersten und zweiten gedruckten Schaltung, so daß diese einander gegenüberliegen.

## Revendications

1. Equipement miniature mobile de radio-communications ayant un dispositif de blindage pour la protection électromagnétique mutuelle d'au moins une section émettrice et une section réceptrice, composé des éléments suivants :
une première carte de circuits imprimés (10a) chargée de divers composants (102) constituant la section émettrice (100) sur une surface de ladite carte et dont les bornes desdits composants sont connectées sur cette surface ;
une seconde carte de circuits imprimés (106) chargée de divers autres composants (202) constituant la section réceptrice (200) sur une surface et dont les bornes desdits composants sont connectées sur cette surface, lesdites première et seconde cartes de circuits imprimés étant situées de telle façon que les autres surfaces se font face ; et
un moyen de blindage (500, 600, 700) pour la protection électromagnétique mutuelle des sections émettrice et réceptrice.

2. Equipement selon la revendication 1, dans lequel lesdites première et seconde cartes de circuits imprimés sont espacées l'une de l'autre et lesdites autres surfaces sont attenantes l'une à l'autre.

3. Equipement selon la revendication 1, dans lequel lesdites première et seconde cartes de circuits imprimés sont situées avec lesdites autres surfaces en contact l'une avec l'autre.

4. Equipement selon la revendication 1, dans lequel ledit moyen de blindage comporte des pièces de mise à la masse prévues respectivement sur des surfaces opposées desdites première et seconde cartes de circuits imprimés.

5. Equipement selon la revendication 1, dans lequel ledit moyen de blindage comporte une feuille isolante (500) intercalée entre lesdites autres surfaces desdites première et seconde cartes de circuits imprimés.

6. Equipement selon la revendication 1, dans lequel ledit moyen de blindage comporte une tôle métallique (600) intercalée entre lesdites autres surfaces desdites première et seconde cartes de circuits imprimés.

7. Equipement selon la revendication 1, dans lequel ledit moyen de blindage comporte une tôle métallique (600) intercalée entre lesdites autres surfaces desdites première et seconde cartes de circuits imprimés, et deux feuilles isolantes (500a, 500b) respectivement montées sur les surfaces opposées de ladite tôle métallique.

8. Equipement selon la revendication 1, comportant en outre un boîtier (400) destiné à recevoir lesdites première et seconde cartes de circuits imprimés et ledit moyen de blindage.

9. Equipement selon la revendication 8, dans lequel ledit boîtier comporte un capot pour la section de transmission (104), un capot pour la section de réception (204) et des éléments de support opposés l'un à l'autre (412a, 412b).

10. Equipement selon la revendication 9, dans lequel ledit capot pour la section de transmission et ledit capot pour la section de réception et lesdits éléments de support sont en métal.

11. Equipement selon la revendication 9, comportant en outre des moyens de fixation desdites première et seconde cartes de circuits imprimés et dudit moyen de blindage dans ledit boîtier.

12. Méthode de montage de la première et de la seconde sections de radio d'un équipement selon la revendication 1, comportant les opérations suivantes :
montage de ladite première section radio (100) sur une surface d'une première carte de circuits imprimés (10a) ayant une première pièce de mise à la masse sur son autre surface ;
montage de ladite seconde section radio (200) sur une surface d'une seconde carte de circuits imprimés (10b) ayant une seconde pièce de mise à la masse sur son autre surface et
présentation des autres surfaces desdites première et seconde cartes de circuits imprimés de façon à ce qu'elles soient en face l'une de l'autre.
